(19) Europäisches Patentamt / European Patent Office / Office européen des brevets

(11) **EP 4 607 272 A1**

(12) **EUROPEAN PATENT APPLICATION**

(43) Date of publication:
**27.08.2025 Bulletin 2025/35**

(21) Application number: **24382178.2**

(22) Date of filing: **20.02.2024**

(51) International Patent Classification (IPC):
**G03F 1/36** $^{(2012.01)}$    **G03F 1/50** $^{(2012.01)}$
**G03F 7/00** $^{(2006.01)}$    **G03F 7/20** $^{(2006.01)}$
**G03H 1/00** $^{(2006.01)}$    **G03H 5/00** $^{(2006.01)}$

(52) Cooperative Patent Classification (CPC):
**G03F 1/36; G03F 1/50; G03F 7/2037; G03F 7/2045;
G03F 7/70408; G03H 1/0005; G03H 1/024;
G03H 1/0808; G03H 5/00; H01J 37/3175;**
G03H 2001/0094; G03H 2001/0816; G03H 2240/12;
G03H 2260/63

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Lace Lithography AS
5007 Bergen (NO)**

(72) Inventors:
• **Salvador Palau, Adrià
08005 Barcelona (ES)**
• **Fojo Alvarez, Daniel
08014 Barcelona (ES)**
• **Hébert, Antoine
08013 Barcelona (ES)**

(74) Representative: **LIGL IP Consult AS
Apotekergata 10
0180 Oslo (NO)**

(54) **SYSTEM AND METHOD FOR THE DESIGN AND CREATION OF A LITHOGRAPHY MASK**

(57)    A computer implemented method and a data processing system for the design and creation of a lithography mask (4) configured to be arranged between a source (2) with a beam (21) and a target (5) wherein the target has a predefined desired pattern (51), wherein the method comprises;
- creating an initial mask template (41) with mask template properties (401),
- repeatedly until an intermediate error (62) is acceptable (60);
- predicting an intermediate pattern (52) produced in the target (5) by the mask template (42),
- determining the intermediate error (62) of the intermediate pattern (52) relative to the desired pattern (51), and
- improving the mask template properties (401) of the mask template (42) based on the error (60).

Fig. 2

**Description**

TECHNICAL FIELD

The present invention relates to the field of lithography and more specifically to the design and/or creation of a lithography mask that may be used in a microlithography system for e.g., production of integrated circuits.

BACKGROUND

The fabrication of integrated circuits is currently based on pattern generation using mask-based photolithography: An enlarged version of the desired chip pattern or part of the desired chip pattern is printed on a substrate (photomask). The pattern on the mask may be distorted to account for aberration effects etc.. Light (photons) are transmitted through or reflected off the photomask using optical components (refractive or reflective lenses) to create a demagnified image of the pattern on a silicon wafer. The silicon wafer is coated with a photosensitive material (resist), which reacts with the photons thus creating a permanent imprint of the image in the resist. This is then used as a physical mask in the following fabrication steps. The two main light sources used in the semiconductor industry today are Deep Ultraviolet Light (DUV) which has a wavelength of 193 nm and Extreme Ultraviolet Light (EUV) which has a wavelength of 13.5 nm.

As an alternative to photolithography, some publications propose to use particle beams instead of photolithography, since the high energy of the photons will limit the feature size to be achieved to around 6 nm for EUV. This is due to the photo-generated secondary electrons, which can travel for several nm before inducing a reaction.

The generated pattern, or desired pattern, will in real life situations be determined by the circuit design of the manufactured items, such as e.g. integrated circuits. It is therefore necessary to produce the mask based on the desired pattern. This is often referred to as the inverse problem.

Most of the particle-based lithography is grid-based binary holography where the openings are all of the same size and placed on the membrane at positions defined by a regular, square grid structure.

Nesse, T., Simonsen, I., Holst, B.: Nanometer-Resolution Mask Lithography with Matter Waves: Near-Field Binary Holography. Phys. Rev. Applied 11, 024009 (2019). https://doi.org/10.1103/PhysRevApplied.11.024009 disclosed theoretical work on grid based binary holography with the application of small masks with square and hexagonal grid structures, a distance between the mask and the pattern plane of only $40\mu$m and very small holes, less than 1 nm.

While optical lithography uses well known production methods of photomasks with opaque and transparent areas, particle-based lithography, such as metastable atoms, may use solid masks with holes. The following illustrates some of the development and established technology for mask production in this field.

The production of physical masks for metastable atom manipulation via diffraction is an established technology.

Fujita et al., Manipulation of an atomic beam by a computer-generated hologram Nature 380 691 (1996) discloses manipulation of atoms to generate a specific, nonperiodic pattern using a mask made of a solid material Here a mask with 300 nm diameter through holes were made in a 100 nm thick SiN membrane. The mask was produced by first coating the membrane with a resist layer, followed by writing the desired mask pattern in the resist using electron beam writing. Subsequent CF4 plasma etching was used to create through holes in the membranes. The mask was used to manipulate a beam of metastable neon atoms.

S. D. Eder et al, Focusing of a neutral helium beam with a photon-sieve structure, Phys. Rev. A 91, 043608 (2015) discloses a so-called atom sieve, made by a similar procedure, was used to manipulate a beam of ground state atoms. The mask consisted of 31991 holes with diameters ranging from 1840 to 150 nm.

Y. Yang et al, Nanostructured-membrane electron phase plates, Ultramicroscopy 217 113053 (2020) patterned SiN membranes down to 10 nm thickness using electron beam lithography and reactive ion etching with holes down to around 25 nm and 50 nm pitch.

M. G. Stanford et al. Advanced nanoscale patterning and material synthesis with gas field helium and neon ion beams. J. Vac. Sci. Tech. B 35 030802 (2017) describes using a different technique where a helium ion beam is doing so called direct-write milling into the membrane through holes sub-10 nm through holes (pores).

The prior art binary holography theory for scalar waves, uses a grid of holes with equal size as the base for the masks and assumes system dimensions and wavelength that fulfil the well-known optics condition of Fraunhofer approximation. In the Fraunhofer approximation the inverse problem is reduced to a Fourier transform of the desired pattern, which yields the required mask. Sampling the mask according to the Nyquist-Shannon sampling theorem provides its mode's bandwidth and thus the possible minimum pitch. In one dimension, this can be done analytically as described in prior art. This may also work for matter waves if the holes in the mask are so large that the dispersion force interaction is negligible.

However, the above cannot be adapted to matter waves and masks with smaller holes required for small pitch, because the dispersion force interaction between the particles and the diffraction object induces a complex phase distribution of the matter waves, which is not accounted for in the prior art mask generation theories. In addition, when the Fraunhofer approximation is not fulfilled anymore, the Fourier transform method is no longer valid.

Machine learning has been proposed as a way of solving the inverse problem for masks with smaller holes.

Fiedler, J., Palau, A., Osestad, E., Parviainen, P., Holst, B.: Realistic mask generation for matter-wave lithography via machine learning. ARXIV.ORG, CORNELL UNIVERSITY LIBRARY, 15 July 2022 (2022-07-15), https://arxiv.org/abs/2207.08723, proposes the use of machine learning to generate a 1D mask targeted for metastable atoms. A deep neural architecture is trained to produce an initial approximation of the mask. This approximation is then used to generate the initial population of the genetic optimization algorithm that is able to converge to arbitrary precision.

The prior art mask generation method can only be used to invert 1D patterns with a specific dimension, i.e., the dimension the neural network is trained for. If a pattern with a different resolution or extension has to be inverted, the network has to be trained again, a process that requires a lot of computational resources.

Further, circuit designs are often very complex and varied. It is therefore difficult to train the neural network to handle all different designs, even when they have the same dimensions as the neural network is trained for.

SHORT SUMMARY

A goal of the present invention is to solve the problems related to prior art.

In particular the invention discloses an improved method for generation of mask design based on a desired pattern from a design process. The mask design can then be used in production of the three-dimensional physical lithography mask that is used to produce the real pattern in the target, where the target may be e.g., a wafer with a layer of resist.

Prior art mask generation relies on an abundance of training data which is facilitated by the fact that all patterns are obtained in the Fraunhofer regime. According to the invention, no training is required. Instead, the method and system according to the invention will take any desired pattern as input. A gradient based optimizer is used directly for each new pattern. This means that there are no dimensional constraints when creating the mask. Further, computational resources and mask generation time may be drastically reduced.

While the prior art mask creation by inversion is disclosed only for particle lithography in the Fraunhofer regime, the current invention can be applied for all types of lithography systems, both photon, particle based and scalar waves, as well as such systems in any physical regime.

Finite-length two-dimensional patterns are needed to encode information and logical gates in circuit design. The invention can be used to obtain any realistic two-dimensional pattern used in modern circuit design.

The invention solving the above-mentioned problems is a computer implemented method and system for the creation of a lithography mask according to the independent claims.

BRIEF DESCRIPTION OF THE DRAWINGS

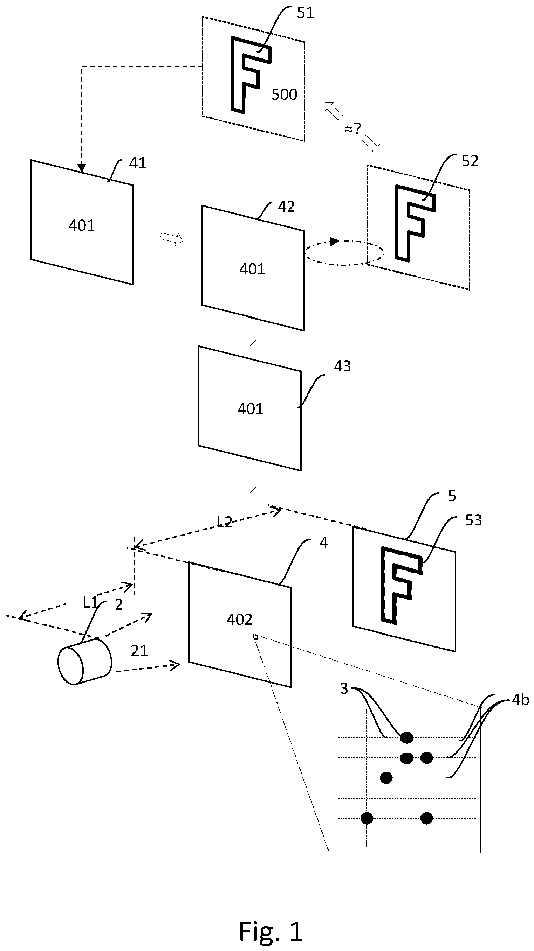

Fig. 1 illustrates schematically an example of a lithography pattern generation system with a mask 4, where the mask may have been created by a system and method according to the invention. The process for designing the mask has been illustrated in a simplified sketch above the lithography pattern generation system.

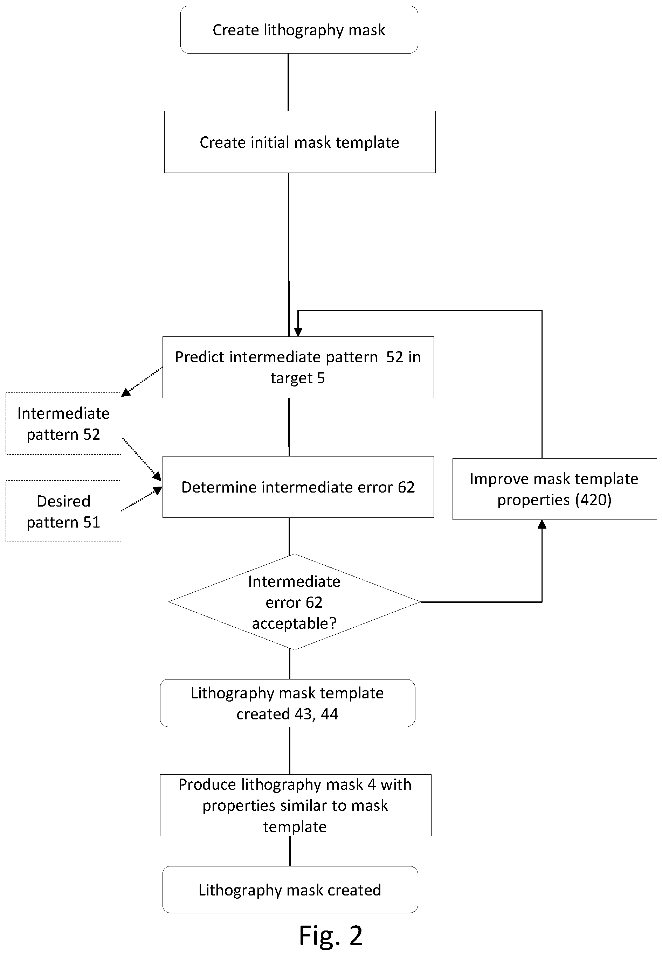

Fig. 2 illustrates in a flow diagram the creation of a lithography mask according to an embodiment of the invention.

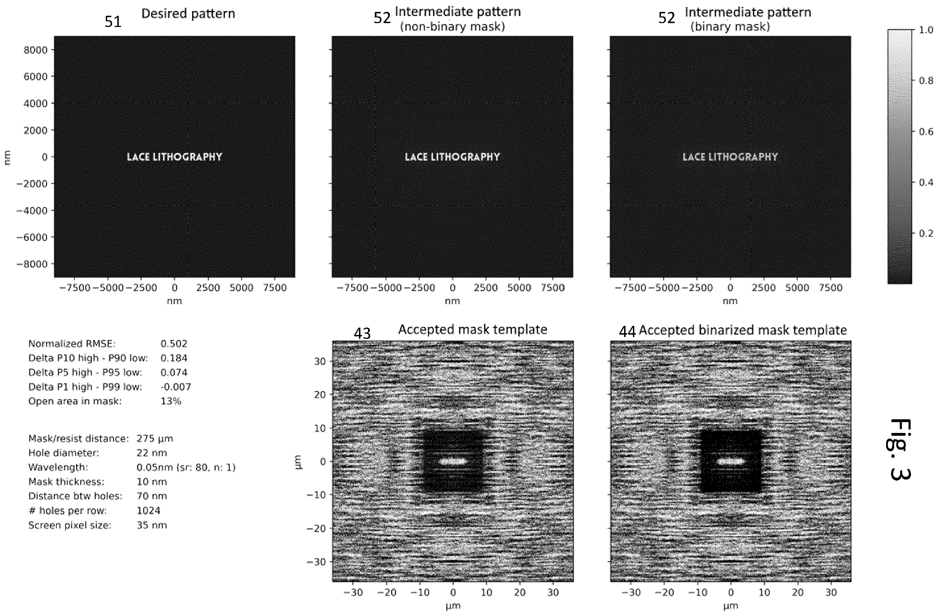

Fig. 3 shows an example of a desired pattern 51 in the upper left, as well as an accepted mask template 43 and an accepted binarized mask template 44 in the lower part. The respective intermediate patterns 52 for the accepted mask template 43 and accepted binarized mask template 44 are shown in the upper part. The intermediate patterns 52 shown here are thus the expected result of a produced pattern 53 in the target 5 for a mask with the same properties as the accepted mask template 43 or the accepted binarized mask template 44. Corresponding system parameters for the setup are listed in the lower left of Fig.3.

As can be seen, binarization of the accepted mask template may result in a slightly degraded quality in the intermediate pattern.

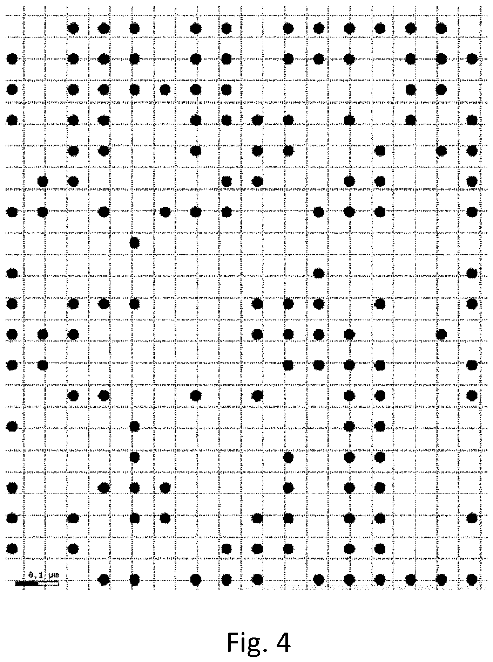

Fig. 4 is a closer look at an accepted binarized mask template 44, where the black dots correspond to binarized area states that are open to the beam used for the lithography process. In the case of particle beams, the binarized area states will correspond to areas 3 that are holes or openings in the produced mask 4. The grid lines are for illustration only.

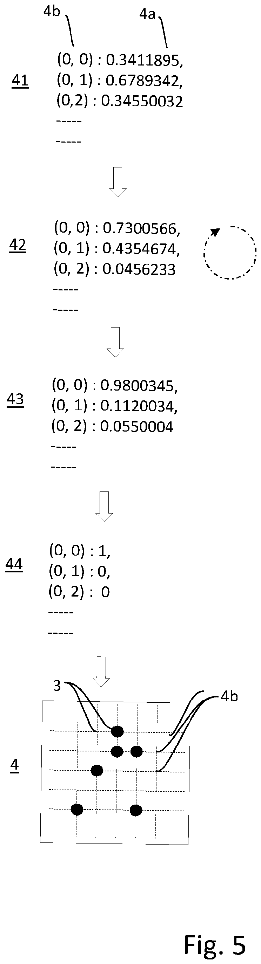

Fig. 5 is an abstract illustration of some of the mask template properties of the initial mask template 41, the mask template 42, the accepted mask template 43, the accepted binarized mask template 44, and the physical mask 4. The area states 4a are in this case randomly generated in the initial mask template 41 and are iteratively improved by gradient descent in the in the mask template state 42, as illustrated by the circular arrow, until the mask template 42 generates a pattern sufficiently similar to the desired pattern, where the mask template 42 is called an accepted mask template 43. In order to produce a physical mask 4, the accepted mask template 43 is binarized into an accepted binarized mask template 44, which serves as the design template for production of the physical mask 4. The area positions 4b in the masks indicates the positions of the areas 3 that correspond to the area states 4a.

In the optical regime, the black dots may of Fig.3 may represent transparent areas in a mask that is otherwise opaque. As an alternative, instead of binarization, translucency of the areas in the mask may vary according to the area state of the accepted mask template 43.

EMBODIMENTS OF THE INVENTION

In the following description, various examples and embodiments of the invention are set forth in order to provide the skilled person with a more thorough understanding of the invention. The specific details described in the context of the various embodiments and with reference to the attached drawings are not intended to be construed as limitations. Rather, the scope of the invention is defined in the appended claims.

The embodiments described below are numbered. In addition, dependent embodiments defined in relation to the numbered embodiments are described. Unless otherwise specified, any embodiment that can be combined with one or more numbered embodiments may also be combined directly with any of the dependent embodiments of the numbered embodiment(s) referred to.

Initially, and before generation of the mask, a desired pattern 51 should be available for the mask generation process. The desired pattern is typically the results of a design process, such integrated circuit design, where the desired pattern may represent areas to be etched in a substrate, such as a silicon wafer, to obtain a layer of the circuit after etching of a resist on the substrate.

Fig. 3 shows an example of such a desired pattern 51 used for illustration purposes.

A number of parameters may be relevant for the mask design. Such parameters may be e.g., write field of the desired pattern of the pattern target, distance between the source and the mask, distance between the mask and the pattern target, source type and wavelength, source beam width, mask height, width and thickness, etc. Such parameters are referred to as system parameters in this document.

An example of system parameters used to produce the produced pattern "LACE LITHOGRAPHY" with a pixel resolution of 35 nm as in Fig. 3, could be the following:

- mask size: 39,28 $\mu$m
- mask thickness:10 nm
- hole radii: 22nm
- L1: 0.5m
- L2: 0,000275m
- distance between area centres: 70nm.

In a specific embodiment EM1-1, the invention is a computer implemented method for the creation of a lithography mask 4 configured to be arranged between a source 2 with a beam 21 and a target 5 wherein the target has a predefined desired pattern 51.

The method comprises;

- creating an initial mask template 41 with mask template properties 401,
- starting with the initial mask template, repeatedly until an intermediate error 62 is acceptable 60;

  a - predicting an intermediate pattern 52 produced in the target 5 by the mask template 42,
  b - determining the intermediate error 62 of the intermediate pattern 52 relative to the desired pattern 51, and
  c - improving the mask template properties 401 of the mask template 42 based on the error 60.

EM1-2. The computer implemented method of EM1-1, wherein the mask template properties 420 comprise area states 42a, where an area state indicates whether a corresponding area 3 in the mask 4 should be open, closed or partially open for the beam 21 to pass through.

EM1-3. The computer implemented method of EM1-2, wherein the area state 4a is represented by a numerical value selected from a predefined set of numbers.

EM1-4. The computer implemented method of EM1-3, wherein boundary values of the set represent respective open and closed areas 3 in the mask 4.

The set of numbers may be e.g. a range of decimal numbers or integers.

If decimal numbers are used, they can be represented by floating point numbers.

EM1-5. The computer implemented method of any of EM1-2 to EM1-4, wherein an area state 4a with a value of open indicates that the area has a through hole and the closed state indicates that the area is solid. As indicated previously, solid masks with holes are used in particle lithography, such as atomic beam lithography.

EM1-6. The computer implemented method of any of EM1-2 to EM1-4, wherein an area state 4a with a value an open indicates that the area is transparent, and the closed state indicates that the area is opaque for the beam 21. The area states may represent transparent and opaque areas used in optical lithography.

EM2-1. The computer implemented method of any of EM1-2 to EM1-6, wherein the mask template properties comprise an area position 42b for each area state 42a, wherein an area position defines a physical position 4b of the area 3 in the mask 4.

EM2-2. The computer implemented method of EM2-1, wherein an area position 4b is represented by a set of coordinates.

EM3-1. The computer implemented method of any of EM1-1 to EM2-2, wherein only a single initial mask template 41 is created.

EM3-2. The computer implemented method of any of EM1-1 to EM3-1, wherein the values for the area states 42a are randomly generated for the initial mask template 41.

EM3-3. The computer implemented method of any of EM1-1 to EM3-1, wherein the values for the area states 42a are equal for the initial mask template 41.

EM3-4. The computer implemented method of any of EM1-1 to EM3-3, wherein the step of creating the initial mask template comprises using parameters representing any of the width height and thickness of the mask 4 or a writeable area of the mask.

EM3-5. The computer implemented method of any of EM2-1 to EM3-4, wherein a number of area positions 42b is calculated as a function of parameters representing any of the width, height and thickness of the mask 4 or a writeable area of the mask 4.

EM3-6. The computer implemented method of any of EM2-1 to EM3-5, wherein a width of the area 3 is pre-defined.

EM3-7. The computer implemented method of any of EM1-1 to EM3-6, wherein the initial single mask template 41 is untrained. I.e. the area states 42a have not been determined by an initial training process.

EM 4-1. The computer implemented method of any of EM1-1 to EM3-7, the step of predicting the intermediate pattern 52 is performed by numerical calculation of at least some of the contributions from the mask template properties 400. The numerical calculation may comprise numerical integration.

EM4-2. The computer implemented method of EM4-1, wherein the step of predicting the intermediate pattern 52 is performed by numerical calculation of the area state 42a values of the mask template properties 400. The numerical calculation may comprise numerical integration.

EM4-3. The computer implemented method of EM4-2, wherein the intermediate pattern 52 is obtained by calculating the intensity I from the mask template 42, where $I= |SUM(C\_h*W\_h)|^2$, where $W\_h$ is the complex intensity resulting from having each individual hole open over the entire screen, and $C\_h$ is the area state value within the boundaries of the number set used.

EM4-4. The computer implemented method of any of EM4-1 to 4-3, comprising changing the size of the area 3. The maximum size of the area is determined by the grid of the mask defined by the system parameters.

EM5-1. The computer implemented method of any of EM1-1 to EM4-4, wherein the step of creating an initial mask template 41 comprises; - preprocessing the values of the area states 42a with a differentiable function to compress the values of the area states 42a into a pre-defined interval, wherein the interval boundaries represent the open and closed states of the cell.

EM5-2. The computer implemented method of EM5-1, wherein the preprocessing is performed by a sigmoid function.

EM5-3. The computer implemented method of EM5-2, wherein the values of the area states 42a are multiplied by a number less than 1 before handled by the sigmoid function to map the numbers closer to the set boundaries.

EM5-4. The computer implemented method of EM5-3, wherein the set boundaries are 0 and 1, respectively.

EM5-5. The computer implemented method of EM-5-4, wherein the 1 represents a completely open cell and 0 comprises a completely closed cell, or vice-versa.

EM6-1. The computer implemented method of any of EM1-1 to EM5-5, wherein the step of determining an intermediate error 62 comprises;

- determining the intermediate error by a differentiable error function.

EM6-2. The computer implemented method of EM6-1, wherein a change in the intermediate error 62 is linked to a change in the mask template properties 400.

EM6-3. The computer implemented method of EM6-1 or EM6-2, wherein the intermediate error is determined by;

$$\text{intermediate error } 62 = \text{Loss}(I(\sigma(x)) - P),$$

where Loss is a loss function, I is the numerical calculation process, x is the mask template properties and P is the desired pattern 52.

EM6-4. The computer implemented method of EM6-3, wherein the Loss function is any of Mean Squared Error, Mean Absolute Error and Binary Cross Entropy.

EM6-5. The computer implemented method of EM6-3 or EM6-4, wherein the loss function penalizes area state 42a values close to the middle of the set and forces these values closer to the boundaries of the set. E.g., if some area state values are 0.4356734 and 0,5784563, new values may be 0,2000000 and 0,8000000, respectively.

EM6-6. The computer implemented method of EM6-5, wherein the intermediate error is determined by;

$$\text{intermediate error } 62 = \text{Loss}(I(\sigma\_T(x) - 0.5)^2 - P),$$

where $\sigma\_T$ is a low temperature sigmoid function.

EM7-1. The computer implemented method of any of EM1-1 to EM6-6, comprising;

- assigning a binary number to each of the area states 42a of the accepted mask template 43.

EM7-2. The computer implemented method of EM7-1, wherein the area state values are rounded to the nearest binary number.

EM8-1. The computer implemented method any of EM1-1 to EM7-2, wherein the mask template 42 comprises a matrix comprising the area states 42a.

EM8-2. The computer implemented method EM8-1, wherein the matrix is two-dimensional.

EM8-3. The computer implemented method of EM8-1 or 8-2, wherein the dimension of the matrix is pre-defined.

EM8-4. The computer implemented method of any of EM8-1 to EM8-3, wherein the desired pattern 51 has a predefined feature size, and the dimension of the matrix is a function of the feature size.

EM8-5. The computer implemented method any of EM1-1 to EM7-2, wherein the mask template 42 comprises a dictionary structure comprising the area states 42a.

EM8-6. The computer implemented method of EM8-5, wherein the dictionary structure comprises area positions 42b corresponding to the area states 42a.

EM9-1. The method of any of the embodiments above; comprising producing the lithography mask 4 with mask properties 400 of an accepted mask template 43 similar to the mask template 42.

Since the method and system of the invention may be used for different types of lithography and optical regimes, the masks may be produced by different techniques. While optical lithography uses well known production methods of photomasks with opaque and transparent areas, particle-based lithography, such as metastable atom lithography, may use solid masks with holes produced as explained in the references in the background section.

The invention may also be described as other independent embodiments, such as:

ED1. A data processing system comprising means for carrying out the method of any of EM1-1 to EM9-1.

ED2: A computer program comprising instructions which, when the program is executed by a computer, cause the computer to carry out any of EM1-1 to EM9-1.

ED3: A computer-readable medium comprising instructions which, when executed by a computer, cause the computer to carry out any of EM1-1 to EM9-1.

ED4: A computer implemented method for the creation of a lithography mask design, comprising the steps of any of EM1-1 to EM9-1.

A specific embodiment will now be explained with reference to the drawings.

Fig. 1 illustrates a schematically a specific embodiment of a lithography pattern generation system 1 where a mask 4 created by the invention may be applied to obtain the desired pattern 51. The system 1 comprises an incoming particle beam 21 from a particle source 2 and a mask 4 arranged in the incoming particle beam 21 between the particle source 2 and a pattern target 5. A produced pattern 53 on the pattern target results from the particles diffracted by the mask 4. The source distance L1 and the pattern target distance L2 from the particle source 2 to the mask 4 and from the mask 4 to the pattern target 5, respectively, are indicated. Further, the mask 4 comprises through holes 3.

The produced pattern 53 may be slightly different from the desired pattern 51. E.g., the produced pattern may have a lower contrast in some areas than the desired pattern or some noise as indicated by the small irregularities along the edges of the pattern in Fig. 1. However, as long as the produced pattern 53 is within pre-defined tolerances, minor differences inherent in all types of lithography, can be accepted.

Given the desired pattern 51 and the system parameters, mask design and production can take place. Fig. 2 illustrates how the process may take place in an embodiment. The initial steps are computer implemented and comprises generating an initial mask template 41, which in this embodiment may be a two-dimensional random matrix of floating-point numbers in the cells, where the cells values are area state 42a values.

The dimension of the random matrix depends on the system parameters.

Each of the random floating-point numbers, i.e. area states, in the initial mask template 41 are then compressed or normalized into the [0,1] interval, where 1 may represent a fully open hole in the corresponding area 3 of the mask 4, and 0 may represent a solid or blocked hole. Cell values, i.e. are states in between 0 and 1 represent areas that are partly open. However, since holes cannot be partly open, the cell values need to be refined until a mask pattern consisting only of closed and open values is found to give the desired pattern.

A sigmoid function is used for compression, where x is the random floating-point number. In order to map the numbers closer to 0 and 1, a specialized sigmoid function $\sigma(x/T)$ with a temperature parameter T may be used.

The compression may be done with other kind of functions as long as they are differentiable.

At this stage, the matrix, which for clarity is called a mask template 42, therefore comprises floating point numbers in the range [0,1].

Even though the numbers are decimal numbers between 0 and 1, and not binary, we can still treat the cells in the mask template 42 in a similar way to a binary matrix.

In order to determine the intermediate pattern 52, the intensity I from the mask template 42 is calculated, where I= |SUM(C_h*W_h)|^2, where W_h is the complex intensity resulting from having each individual hole open over the entire screen, and C_h is the area state value within the boundaries of the number set used.

The intermediate pattern 52 is then compared to the desired pattern 53 by determining an error quantity given by Loss(I($\sigma$(x)) - P), where Loss is the loss function, I is the numerical calculation process, x is the mask parameters and P is the desired pattern 52.

The loss function has a negative gradient in the direction of the minimum loss.

Given the gradient of the loss function, the mask properties, i.e., the area state 42a values, may be updated by applying a gradient descent method, such as Gradient Descent, Newton Method, Quasi-Newton Methods (including BFGS, conjugate gradients, global optimization methods that use gradient descent etc.).

The updated mask is again a mask template 42 for which an intermediate pattern 52 can be determined and be iteratively improved by repeating the steps above until the difference between the intermediate pattern 52 and the desired pattern 51 is within predefined limits and we obtain an accepted mask template 43. In Fig. 1, a circular arrow has been used to indicate the gradient descent iterations. Further, the question mark between the desired pattern 51 and the intermediate pattern 52 illustrates that the iteration continues until the difference or error is within acceptable limits.

In cases where the produced mask has through holes, it is necessary to binarize the cell values of the acceptable mask before production, since only binary values give meaning in this case.

Once this iterative process has finished, the accepted mask template 43 may therefore be binarized by assigning 0 or 1 to each decimal, represented by floating-point numbers in the matrix cells. This binarization will generate an error, and if we integrate the binarized accepted mask template, we will not get the exact same pattern as with the nonbinarized accepted mask template.

This error may be minimized by modifying the function that maps the values of the mask to a number between 0 an 1, This function can be devised such that for most real inputs, the outputs are 0 or 1, e.g., a sigmoid function at low temperature. This would modify the loss function above

One example of a binarization term can be:

$$\text{intermediate error 62} = \text{Loss}(I(\sigma\_T(x) - 0.5)^2 - P),$$

where $\sigma$_T is a sigmoid function with a temperature parameter such that the most of its values are close to 0 or 1 (corresponding to a low temperature parameter).

The loss function now penalizes numbers close to 0.5, forcing them to go to either 0 or 1.

Alternatively, the threshold used for binarization can be changed from 0.5 to any other threshold. The optimal threshold will be the one that after binarization produces a pattern that reduces the final error between the desired pattern and the pattern produced by the binarized mask.

In the exemplary embodiments, various features and details are shown in combination. The fact that several features are described with respect to a particular example should not be construed as implying that those features by necessity have to be included together in all embodiments of the invention. Conversely, features that are described with reference to different embodiments should not be construed as mutually exclusive. As those with skill in the art will readily understand, embodiments that incorporate any subset of features described herein and that are not expressly interdependent have been contemplated by the inventor and are part of the intended disclosure. However, explicit description of all such embodiments would not contribute to the understanding of the principles of the invention, and consequently some permutations of features have been omitted for the sake of simplicity or brevity.

**Claims**

1. A computer implemented method for the creation of a lithography mask (4) configured to be arranged between a source (2) with a beam (21) and a target (5) wherein the target has a predefined desired pattern (51), wherein the method comprises;

   - creating an initial mask template (41) with mask template properties (401),
   - repeatedly until an intermediate error (62) is acceptable (60);
   - predicting an intermediate pattern (52) produced in the target (5) by the mask template (42),
   - determining the intermediate error (62) of the intermediate pattern (52) relative to the desired pattern (51), and
   - improving the mask template properties (401) of the mask template (42) based on the error (60).

2. The computer implemented method of claim1, wherein the mask template properties (420) comprise area states (42a), where an area state indicates whether a corresponding area (3) in the mask (4) should be open, closed or partially open for the beam (21) to pass through.

3. The computer implemented method of claim 2, wherein the area state (4a) is represented by a numerical value selected from a predefined set of numbers.

4. The computer implemented method of claim 3, wherein boundary values of the set represent respective open and closed areas (3) in the mask (4).

5. The computer implemented method of claim4, wherein the mask template properties comprise an area position (42b) for each area state (42a), wherein an area position defines a physical position (4b) of the area (3) in the mask (4).

6. The computer implemented method of any claim 1 to 5, wherein the step of predicting the intermediate pattern (52) is performed by numerical calculation of at least some of the contributions from the mask template properties (400).

7. The computer implemented method of any of claim 1 to 6, wherein the step of creating an initial mask template (41) comprises;

   - preprocessing the values of the area states (42a) with a differentiable function to compress the values of the area states (42a) into a pre-defined interval, wherein the interval boundaries represent the open and closed states of the cell.

8. The computer implemented method of any of any of the claims 1 to 7, wherein the step of determining an intermediate error (62) comprises;

   - determining the intermediate error by a differentiable error function.

9. The computer implemented method of any of claim 8, wherein the intermediate error is determined by;

$$\text{intermediate error (62)} = \text{Loss}(I(\sigma(x)) - P),$$

where Loss is a loss function, I is the numerical calculation process, x is the mask template properties and P is the desired pattern (52).

10. The computer implemented method of any of any of the claims 1 to 9, comprising;

   - assigning a binary number to each of the area states (42a) of the accepted mask template (43).

11. The method of any of the claims 1 to 10, comprising producing the lithography mask (4) with mask properties (400) of an accepted mask template (43) similar to the mask template (42).

12. A data processing system comprising means for carrying out any of the methods in claims 1 to 10.

13. A computer program comprising instructions which, when the program is executed by a computer, cause the computer to carry out any of the methods in claims 1 to 10.

14. A computer-readable medium comprising instructions which, when executed by a computer, cause the computer to carry out any of the methods in claims 1 to 10.

15. A computer implemented method for the creation of a lithography mask design, comprising the methods in claims 1 to 10.

Fig. 1

```
                    ┌─────────────────────────────┐
                    │   Create lithography mask   │
                    └─────────────────────────────┘
                                   │
                    ┌─────────────────────────────┐
                    │  Create initial mask template │
                    └─────────────────────────────┘
                                   │
```

Predict intermediate pattern 52 in target 5

Intermediate pattern 52

Desired pattern 51

Determine intermediate error 62

Improve mask template properties (420)

Intermediate error 62 acceptable?

Lithography mask template created 43, 44

Produce lithography mask 4 with properties similar to mask template

Lithography mask created

Fig. 2

Fig. 3

51 Desired pattern

52 Intermediate pattern
(non-binary mask)

52 Intermediate pattern
(binary mask)

LACE LITHOGRAPHY

LACE LITHOGRAPHY

LACE LITHOGRAPHY

Normalized RMSE:              0.502
Delta P10 high - P90 low:     0.184
Delta P5 high - P95 low:      0.074
Delta P1 high - P99 low:      -0.007
Open area in mask:            13%

Mask/resist distance:  275 µm
Hole diameter:         22 nm
Wavelength:            0.05nm (sr: 80, n: 1)
Mask thickness:        10 nm
Distance btw holes:    70 nm
# holes per row:       1024
Screen pixel size:     35 nm

43 Accepted mask template

44 Accepted binarized mask template

EP 4 607 272 A1

12

Fig. 4

Fig. 5

Europäisches
Patentamt

European
Patent Office

Office européen
des brevets

# EUROPEAN SEARCH REPORT

**Application Number**

EP 24 38 2178

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/197213 A1 (UNGAR P JEFFREY [US]) 27 June 2019 (2019-06-27) * paragraphs [0012] - [0014], [0080] - [0093]; figure 9A * | 1-15 | INV.<br>G03F1/36<br>G03F1/50<br>G03F7/00<br>G03F7/20 |
| X | PANG LINYONG (LEO) ED - SPIE-INTERNATIONAL SOCIETY FOR OPTICAL ENGINEERING: "Inverse lithography technology: 30 years from concept to practical, full-chip reality", JOURNAL OF MICRO/NANOLITHOGRAPHY, MEMS, AND MOEMS, SPIE - INTERNATIONAL SOCIETY FOR OPTICAL ENGINEERING, US, vol. 20, no. 3, 1 July 2021 (2021-07-01), page 30901, XP060145308, ISSN: 1932-5150, DOI: 10.1117/1.JMM.20.3.030901 [retrieved on 2021-08-31] * sections 2 and 5.2 * | 1-15 | G03H1/00<br>G03H5/00 |

**TECHNICAL FIELDS SEARCHED (IPC)**

G03F
G03H

The present search report has been drawn up for all claims

| Place of search | Date of completion of the search | Examiner |
|---|---|---|
| Munich | 10 October 2024 | Weckesser, Jens |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 24 38 2178

This annex lists the patent family members relating to the patent documents cited in the above-mentioned European search report.
The members are as contained in the European Patent Office EDP file on
The European Patent Office is in no way liable for these particulars which are merely given for the purpose of information.

10-10-2024

| Patent document cited in search report | Publication date | Patent family member(s) | Publication date |
|---|---|---|---|
| US 2019197213 A1 | 27-06-2019 | CN 111758072 A | 09-10-2020 |
| | | KR 20200091914 A | 31-07-2020 |
| | | TW 201937269 A | 16-09-2019 |
| | | TW 202311848 A | 16-03-2023 |
| | | US 2019197213 A1 | 27-06-2019 |
| | | US 2020279065 A1 | 03-09-2020 |
| | | WO 2019125872 A1 | 27-06-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **NESSE, T.** ; **SIMONSEN, I.** ; **HOLST, B.** Nanometer-Resolution Mask Lithography with Matter Waves: Near-Field Binary Holography. *Phys. Rev. Applied*, 2019, vol. 11, 024009, https://doi.org/10.1103/PhysRevApplied.11.024009
- **FUJITA et al.** Manipulation of an atomic beam by a computer-generated hologram. *Nature*, 1996, vol. 380, 691
- **S. D. EDER et al.** Focusing of a neutral helium beam with a photon-sieve structure. *Phys. Rev. A*, 2015, vol. 91, 043608

- **Y. YANG et al.** Nanostructured-membrane electron phase plates. *Ultramicroscopy*, 2020, vol. 217, 113053
- **M. G. STANFORD et al.** Advanced nanoscale patterning and material synthesis with gas field helium and neon ion beams. *J. Vac. Sci. Tech. B*, 2017, vol. 35, 030802
- Realistic mask generation for matter-wave lithography via machine learning. **FIEDLER, J.** ; **PALAU, A.** ; **OSESTAD, E.** ; **PARVIAINEN, P.** ; **HOLST, B.** ARXIV.ORG. CORNELL UNIVERSITY LIBRARY, 15 July 2022